# EUROPEAN PATENT APPLICATION

(11) **EP 2 544 377 A2**
(43) Date of publication of application: **09.01.2013**
(21) Application number: 11009702.9
(22) Date of filing: 08.12.2011
(51) Int. Cl.: H04B 1/18

(54) **Closed loop antenna tuning using transmit power control commands**

(30) Priority: 16.12.2010 US 969642
(71) Applicant: Sony Ericsson Mobile Communications AB, 221 88 Lund (SE)
(72) Inventor: Camp, William, Chapel Hill, NC 27514 (US)
(74) Representative: Banzer, Hans-Jörg

(57) **Abstract**

A method and apparatus for closed loop antenna tuning uses power control feedback from a serving base station to infer the best impedance settings for an impedance matching circuit. The mobile terminal receives periodic power control commands from a base station and varies a transmit power of the transmit signal responsive to said power control commands. An antenna tuning circuit determines an impedance setting for an impedance matching circuit based on observed variations in the power control commands following adjustment in the impedance matching circuit.

## Description

### BACKGROUND

The present invention relates generally to adaptive antenna tuning for mobile communication devices and, more particularly, to a closed loop antenna tuning method and apparatus using power control feedback for adaptive antenna tuning.

Mobile communication devices with low profile or internal antennas are becoming increasingly popular. Advantages of internal antennas include elimination of protruding objects, reduction in size, and reduced vulnerability to damage. Internal antennas, however, are sensitive to changes in the proximate environment, such as loading due to the placement of a user's hand or proximity of the user's head, the so-called "head and hand effect." Even small changes in the proximate environment can result in significant detuning of the antenna which, in turn, can materially affect the performance of the antenna.

Adaptive antenna tuning circuits or antenna tuning units (ATUs) are known for tuning the antenna in a mobile terminal. The antenna tuning circuit typically comprises an impedance matching circuit (IMC) coupled between the transmitter and/or receiver and its antenna to improve the efficiency of the power transfer by matching the impedance of the antenna to the impedance of the transmitter or receiver. The antenna tuning circuit can be open loop or closed loop. Because an open loop system does not measure the operation of the antenna in real time, it typically does not take into account changes in environmental conditions as seen by the mobile terminal. The proximate environment for a mobile terminal is constantly changing due to changes in the location of the mobile terminal and the "head and hand effect." Closed loop antenna tuning can be used to tune the mobile terminal antenna responsive to changes in the proximate environment of the mobile terminal. For example, a sensor can be used to measure the voltage standing wave ratio (VSWR) and make adjustments to the impedance matching circuit based on VSWR measurements. This solution requires additional hardware to measure the VSWR, which increases the cost and complexity of the mobile terminal. A further disadvantage of measuring VSWR is that it requires the transmitter to be operating at relatively high output power to obtain useful measurement values. This high output power is not often the case in CDMA systems, thus limiting when the VSWR measurement technique can be used.

Accordingly, there is a need for a closed loop antenna tuning method and apparatus that does not rely on VSWR measurements or add additional hardware components to the mobile terminal.

### SUMMARY

The present invention relates to a method and apparatus for closed loop antenna tuning based on power control feedback from a serving base station. Most third generation (3G) and fourth generation (4G) wireless communication networks have some form of active transmit power control for controlling the transmit power of the mobile terminal on the uplink. In embodiments of the present invention, the mobile terminal uses the power control feedback from a serving base station to help find impedance settings for an impedance matching circuit that will improve the performance of the mobile terminal. The basic concept is to observe the effect of changes in the impedance settings of an impedance matching circuit on the power control feedback from the serving base station. Assuming that the changes in the impedance settings are made at a faster rate than the changes in the fading channel, it is possible to find impedance settings for the impedance matching circuit that will improve the performance in terms of power transfer between a transmitter and the transmit antenna. Different search algorithms can be employed to determine the best impedance settings from a set of candidate impedance settings.

In some embodiments of the invention, the power control feedback may be analyzed in conjunction with input from other sources providing information about the proximate environment of the mobile device. For example, sensors may be used to detect the position of a user's hands on the mobile communication device or the position of the mobile communication device relative to the user's head. The antenna tuning circuit can perform a search to determine the best impedance setting for different operating conditions, which can be stored in memory. The antenna tuning circuit may use the look-up table to make coarse setting adjustments of the impedance matching circuit based on the current operating conditions and then use the power control feedback to fine tune the impedance at setting as long as the conditions remain generally the same.

Exemplary embodiments of the invention comprise a method of adjusting an impedance matching circuit in a mobile terminal coupling a transmitter generating a transmit signal to a transmit antenna. One exemplary method comprises receiving periodic power control commands from a base station, varying a transmit power of the transmit signal responsive to said power control commands, and determining an impedance setting for said impedance matching circuit based on said power control commands following adjustment of said impedance matching circuit.

In some embodiments of the method, determining an impedance setting for said impedance matching circuit comprises changing an impedance setting for the impedance matching circuit between a current impedance setting and a candidate setting, monitoring said power control commands following the change in the impedance setting, and selecting between the current impedance setting and the candidate setting based on said power control commands.

In some embodiments of the method, determining an impedance setting for said impedance matching circuit based on said power control commands comprises generating a set of candidate settings for the impedance matching circuit, iterating through the candidate settings by making a series of adjustments in the impedance setting for the impedance matching circuit, determining a reduced set of candidate settings corresponding based on the power control commands following said adjustments, and selecting one of said candidate settings in said reduced candidate set as a current impedance setting.

In some embodiments of the method, determining a reduced set of candidate settings comprises computing a statistic of the power control commands following adjustments to said impedance settings, and finding the candidate settings that correspond to local minima in the statistic.

In some embodiments of the method, computing a statistic of the power control commands following adjustments to said impedance settings comprises integrating the power control commands over a predetermined time period.

In some embodiments of the method, determining a reduced set of candidate settings comprises recursively reducing the candidate set until the reduced candidate set contains a single candidate setting remains.

In some embodiments of the method, determining an impedance setting for said impedance matching circuit based on said power control commands comprises determining two or more impedance settings for different operating conditions.

Some embodiments of the method further comprise detecting a current operating condition of said mobile communication device: and selecting an impedance setting determined based on the current operating condition.

In some embodiments of the method, determining an impedance setting for said impedance matching circuit based on said power control commands comprises determining at least one of a mobility rate of the mobile terminal and a fading rate of a channel between the mobile terminal and a serving base station, and determining the impedance matching circuit when one or both of the mobility rate and the fading rate are below a corresponding threshold.

Some embodiments of the method further comprise detecting a change in a proximate environment of the mobile communication device, and determining an impedance setting for said impedance matching circuit responsive to the detected change in the proximate environment.

In some embodiments of the method, determining an impedance setting for said impedance matching circuit comprises determining the impedance setting at a predetermined search interval.

Other embodiments of the invention comprise a mobile terminal with an antenna tuning circuit, An exemplary mobile terminal comprises a transmitter for transmitting signal to a base station on an uplink channel, a receiver to receive transmit power control commands from said base station on a downlink control channel, an impedance matching circuit coupled between the transmitter and a transmit antenna, and an antenna tuning circuit to determine an impedance setting for said impedance matching circuit based on said power control commands following adjustment of said impedance matching circuit.

In some embodiments of the mobile terminal, the antenna tuning circuit determines an impedance setting for said impedance matching circuit by changing an impedance setting for the impedance matching circuit between a current impedance setting and a candidate setting, monitoring said power control commands following the change in the impedance setting, and selecting between the current impedance setting and the candidate setting based on said power control commands.

In some embodiments of the mobile terminal, the antenna tuning circuit determines an impedance setting for said impedance matching circuit by generating a set of candidate settings for the impedance matching circuit, iterating through the candidate settings by making a series of adjustments in the impedance setting for the impedance matching circuit, determining a reduced set of candidate settings based on the power control command following said adjustments, and selecting one of said candidate settings in said reduced candidate set as a current impedance setting.

In some embodiments of the mobile terminal, the antenna tuning circuit determines a reduced set of candidate settings by computing a statistic of the power control commands following adjustments to said impedance settings, and finding the candidate settings that correspond to local minima in the statistic.

In some embodiments of the mobile terminal, the antenna tuning circuit integrates the power control commands over a predetermined time period to compute the statistic.

In some embodiments of the mobile terminal, the antenna tuning circuit determines a reduced set of candidate settings by recursively reducing the candidate set until a single candidate setting remains.

In some embodiments of the mobile terminal, the antenna tuning circuit determines two or more impedance settings for different operating conditions.

In some embodiments of the mobile terminal, the antenna tuning circuit is further configured to detect a current operating condition of said mobile communication device: and select an impedance setting determined based on the current operating condition.

In some embodiments of the mobile terminal, the antenna tuning circuit is further configured to determine at least one of a mobility rate of the mobile terminal and a fading rate of a channel between the mobile terminal and a serving base station, and determine the impedance matching circuit when one or both of the mobility rate and the fading rate are below a corresponding threshold.

In some embodiments of the mobile terminal, the antenna tuning circuit is further configured to detect a change in a proximate environment of the mobile communication device, and determine an impedance setting for said impedance matching circuit responsive to the detected change in the proximate environment.

In some embodiments of the mobile terminal, the antenna tuning circuit is further configured to determine an impedance setting for said impedance matching circuit by determining the impedance setting at a predetermined search interval.

### BRIEF DESCRIPTION OF THE DRAWINGS

Fig. 1 illustrates an exemplary communication system including a mobile terminal and a serving base station.

Fig. 2 illustrates an exemplary mobile terminal according to one embodiment of the invention.

Figs. 3A and 3B illustrate how power control feedback may be used to adaptively tune a transmit antenna in a mobile terminal.

Fig. 4 illustrates an exemplary antenna tuning procedure implemented in a mobile terminal.

Fig. 5 illustrates an exemplary search method for finding an impedance setting for a mobile terminal.

Fig. 6 illustrates an alternative search method for finding an impedance setting for a mobile terminal.

### DETAILED DESCRIPTION

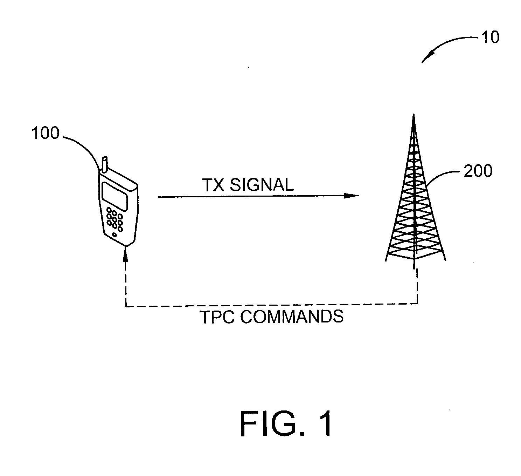

Referring now to the drawings, Fig. 1 illustrates an exemplary mobile communication system 10 including a mobile terminal 100 and a base station 200. The mobile communication system 10 uses uplink power control to control the transmit power of the mobile terminal 100 on the uplink (UL) channel. More particularly, the serving base station 200 controls the transmit power of the mobile terminal 100 by measuring the received signal strength (RSS) and sending transmit power control (TPC) commands on a downlink control channel to the mobile terminal 100 with the goal of maintaining the RSS at some predetermined target value. The target value is typically chosen by an outer loop control mechanism to provide a predetermined target error rate.

In embodiments of the present invention, adaptive antenna tuning of the transmit antenna of the mobile terminal 100 is performed based on power control feedback from the serving base station 200. Most third generation (3G) and fourth generation (4G) wireless communication networks have some form of active transmit power control for controlling the transmit power of the mobile terminal 100 on the uplink. For example, in Wideband Code Division Multiple Access (WCDMA) systems, a base station 200 measures the RSS from a mobile terminal 100 and sends transmit power control (TPC) commands to the mobile terminal 100 at the rate of 1600 transmit power control (TPC) commands per second. The TPC commands comprise a single bit that tells the mobile terminal 100 to either increase or decrease its transmit power by 1 db. For example, a TPC command set to "1" (up command) tells the mobile terminal 100 to increase its power, while a TPC command set to "0" (down command) tells the mobile terminal 100 to decrease its power. The mobile terminal 100 receives the TPC commands over a downlink control channel and adjusts its transmit power accordingly.

The TPC commands can be viewed as a form of feedback indicating how the channel between the mobile terminal 100 and the base station 200 is varying. When the channel is steady and not varying, the number of up and down commands should be nearly equal over a long period. When the channel conditions worsen, the number of up commands relative to the number of down commands should increase. Conversely, if the channel conditions improve, the number of down commands should exceed the number of up commands. Thus, the ratio of up and down commands reflects changes in the channel conditions.

In embodiments of the present invention, the mobile terminal 100 uses the power control feedback from a serving base station 200 to help find impedance settings for an impedance matching circuit that will improve the performance of the mobile terminal 100. The basic concept is to observe the effect of changes in the impedance settings of an impedance matching circuit on the power control feedback from the serving base station 200. Assuming that the changes in the impedance settings are made at a faster rate than the changes in the fading channel, it is possible to find impedance settings for the impedance matching circuit that will improve the performance in terms of power transfer between a transmitter and the transmit antenna. Different search algorithms can be employed to determine the best impedance settings from a set of candidate impedance settings.

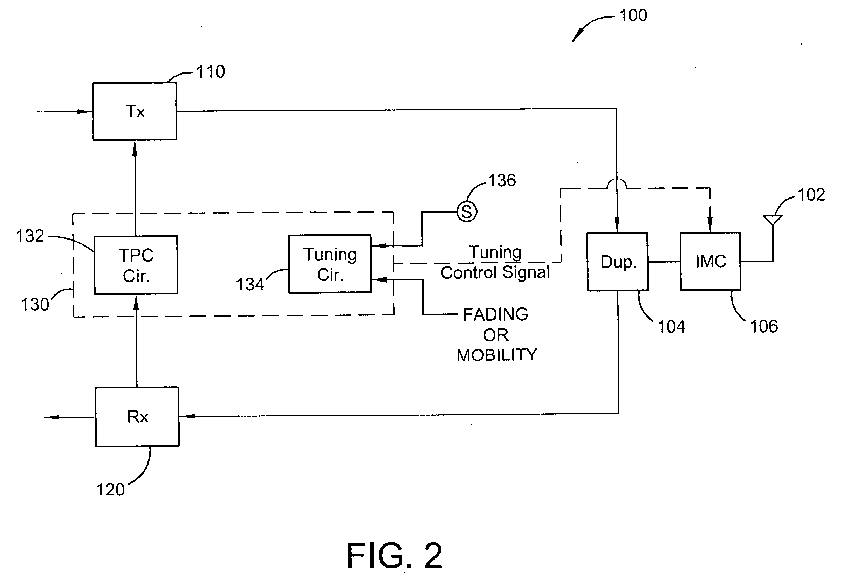

Fig. 2 illustrates an exemplary mobile terminal 100 according to an embodiment of the present invention. The mobile terminal 100 comprises a transmitter 110 and receiver 120 coupled via a switch or duplexer 104 and impedance matching circuit 106 to an antenna 102, and a control circuit 130. The antenna 102 may, for example, comprise an internal antenna that functions as both a transmit antenna and receive antenna. Those skilled in the art will appreciate, however, that the mobile terminal 100 could include separate transmit and receive antennas. The mobile terminal 100 could also include multiple transmit and multiple receive antennas. The transmitter 110 encodes and modulates an information signal for transmission to the base station 200 over a wireless communication channel. The receiver 120 decodes and demodulates signals received by the antenna 102 from a base station 200. The IMC 106 matches the impedance of the antenna 102 to the transmitter 110 and/or receiver 120 as hereinafter described in greater detail.

The control circuit 130 controls the operation of the mobile terminal 100. The control circuit 130 may comprise one or more processors, hardware, firmware, or a combination thereof. The control circuit 130 includes a transmit power control (TPC) circuit 132 and a tuning circuit 134. The TPC circuit 132 adjusts the transmit power of the transmitter 110 according to TPC commands received from a serving base station 200 (not shown). In general, the tuning circuit 134 may change impedance settings for IMC 106 to match the antenna impedance to the transmitter 110 and/or receiver 120. As will be hereinafter described in greater detail, the tuning circuit 134 may use the TPC commands from the serving base station 200 to implement a closed loop antenna tuning method. The tuning circuit 134 may receive information about the proximate environment from a sensor 136, which may comprise a head and/or hand sensor, or an accelerometer. The tuning circuit 134 may also receive information about the mobility rate of the mobile terminal 100 or rate of fading of the communication channel. The tuning circuit 134 generates a control signal that is applied to the IMC 106 for adjusting the impedance setting of the IMC 106.

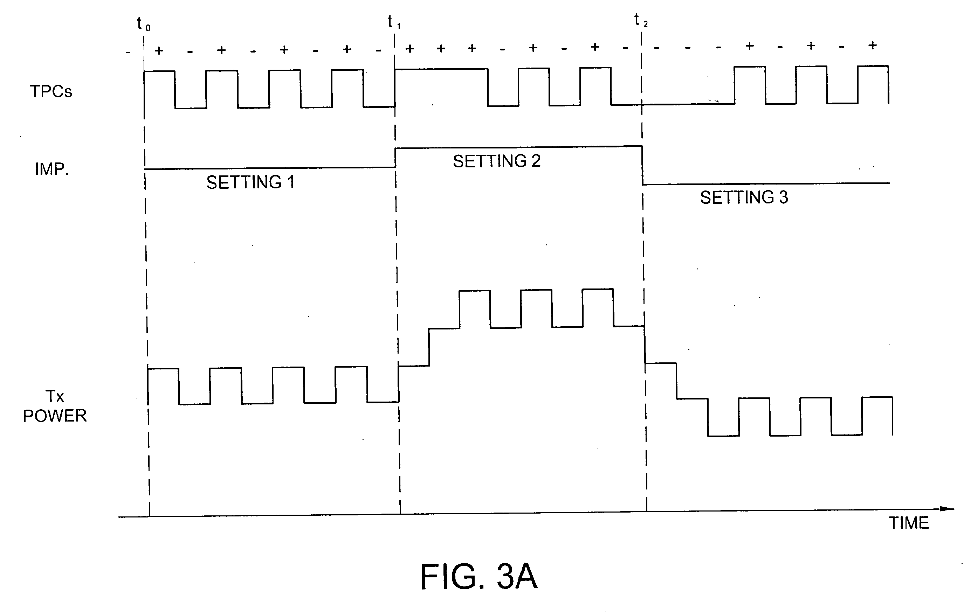

Fig. 3A illustrates how power control feedback may be used to adaptively tune a transmit antenna in a mobile terminal 100. For convenience, the example shown in Fig. 3A assumes that the communication channel between the mobile terminal 100 and the serving base station is steady state and not changing. The top portion of Fig. 3A shows the TPC commands transmitted by the serving base station to the mobile terminal 100. The middle portion of Fig. 3A illustrates changes in the impedance settings for the IMC 106 made by the tuning circuit 134. The bottom portion of Fig. 3A illustrates the transmit power of the mobile terminal 100. In this example the transmit power level follows the TPC commands.

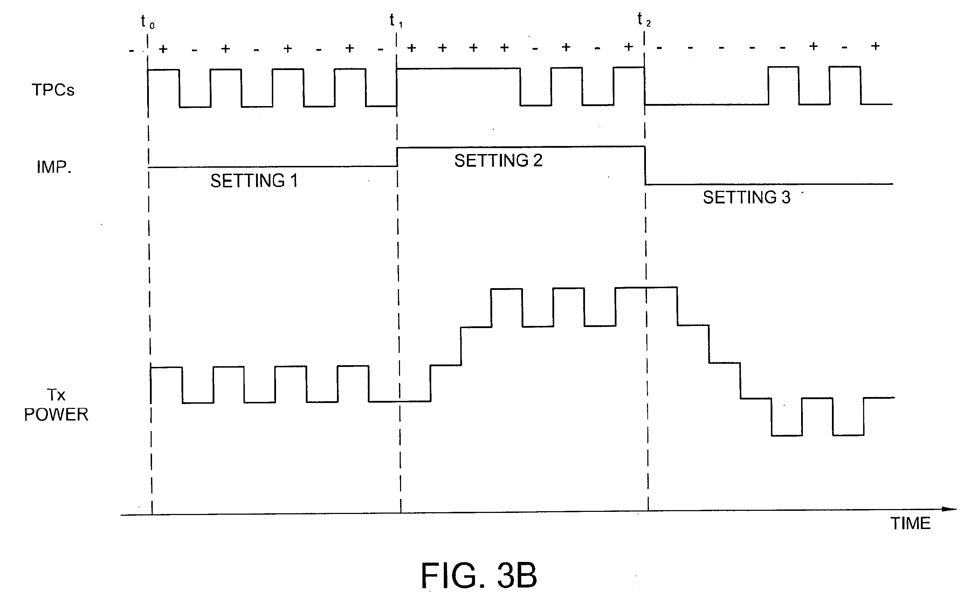

Fig. 3B shows another hypothetical example. The sequence of TPC commands is the same as the example in Figs. 3A; however, the TX signal power does not strictly follow the TPC commands. Instead, the mobile terminal 100 maintains the current TX power setting when it changes the impedance setting regardless of the TPC command.

The hypothetical examples in Fig. 3A and 3B show three different impedance settings denoted Setting 1, Setting 2, and Setting 3. It should be noted that the term "impedance setting" as used herein may involve manipulation of the values of multiple capacitors, inductors, or other circuit components in the IMC 106. That is, the difference between Impedance Setting 1 and Impedance Setting 2 may involve changes in many control variables in the impedance matching circuit. Thus, the term "impedance setting" refers to a set of values for a corresponding set of control variables used to adjust the impedance of the IMC 106.

The basic procedure for adaptively tuning the transmit antenna is to make one or more adjustments in the impedance matching circuit 106 and observe the affects of the adjustments on the TPC commands. Adjustments that improve the impedance match result in more down commands while adjustments that worsen the impedance match result in more up commands. Thus, two different impedance settings can be compared by switching between the settings and observing the affect on the power control commands. Also, a more complex search strategy can be implemented to find the "best" impedance match.

The adjustments can be made periodically, for example, at a rate of 100 times per second (100 Hz). In WCDMA systems, TPC commands occur at the rate of 1600 TPCs per second. Therefore, if the impedance setting is switched every hundredth of a second, there will be 16 power control intervals between changes in the impedance settings. The TPC commands can be observed in an observation interval immediately following the adjustment, which may comprise the 16 power control intervals between changes. The observation interval could, however, be less than the interval between adjustments. For example, the observation interval could comprise 8-12 power control intervals following each adjustment.

Referring back to Figs. 3A and 3B, the transmit power has been adjusted at time to to match the current channel conditions so that the number of up-and-down commands is equal. At time t₁, the IMC 106 is adjusted from Setting 1 to Setting 2. In the observation interval immediately following the adjustment, the ratio of up-to-down commands increases. Based on the assumption that the channel conditions have not changed, it can be inferred that Impedance Setting 2 results in less power transfer between the transmitter 110 and the antenna 102 making Setting 2 less efficient. At time t₂, another adjustment is made in the impedance matching circuit 106 from Setting 2 to Setting 3. In the observation interval following the change, the ratio of the up commands to down commands decreases. Because it is assumed that the channel is steady, it may be inferred that Setting 3 results in more efficient power transfer between the transmitter 110 and antenna 102.

In the example, it might also be possible to infer the relationship between Impedance Setting 1 and Impedance Setting 3. For example, the tuning circuit 134 could perform an integration of the power control bits over the observation interval following each change and compare the magnitude of the integrals. If the magnitude of the interval following the change from Setting 2 to Setting 3 exceeds the magnitude of the change following the change from Setting 1 to Setting 2, then it may be inferred that Setting 3 is an improvement over Setting 1. Alternatively, the tuning circuit 134 could wait for the power control loop to return to a state of equilibrium and then change from Setting 3 back to Setting 1, thus directly comparing Setting 3 with Setting 1.

A number of different search strategies may be employed to find the best impedance settings for the IMC 106. One exemplary search strategy for finding the best impedance setting directly compares a current setting to other candidate settings, and substitutes candidate settings that provide an improved performance compared to the current setting. Settings may be compared by computing a power control statistic for each of the candidate settings being compared based on the power control commands observed following each change.. The power control statistic may, for example, comprise a sum of the up and down commands, the ratio of up and down commands, or an average of the up and down commands in the observation interval following each change. The setting that minimizes (or maximizes) the power control statistic is then selected as the current setting. This strategy, referred to herein as the substitution method, is performed as follows:
1) begin with the current setting;
2) generate set of candidate settings;
3) select untested candidate setting from the candidate set;
4) change from the current setting to a selected candidate setting and compute power control statistic based on observed power control commands;
5) if match improves, make the selected candidate setting the current setting, otherwise return to the current setting; and
6) repeat steps 3-5 for all candidate settings.

Another possible search strategy is to iterate through a set of candidate settings one at a time in any order and compute a power control statistic for each candidate setting based on the power control commands observed in the period following each change. The statistic may, for example, comprise a sum of the up and down commands, the ratio of up and down commands, or an average of the up and down commands in the observation interval following each change. The candidate settings that correspond to local minima in the power control statistic are then selected to form a reduced candidate set. The process is then repeated until the candidate set is reduced to one. This search strategy, referred to as the reduction method, is performed as follows:
1) begin with current setting;
2) generate set of candidate settings;
3) iterate through each candidate settings in the candidate set in no specific order;
4) compute power control statistic based on observed power control commands observe following changes to identify candidate settings that correspond to local minima;
5) take candidate settings corresponding to local minima as a reduced candidate set; and
6) repeat steps 3-5 until candidate set is reduced to one.

In practice, one of the search procedures described above may be performed at some predetermined interval (e.g., every 10-20 seconds) or responsive to some predetermined event (e.g., detection of change in the proximate environment). Each time a search is conducted, the tuning circuit 134 may switch the impedance settings at a rate of approximately 100 Hz. For WCDMA settings, a rate of 100 Hz allows 16 power control intervals between changes in the impedance settings. Depending on the search algorithm used, up to 100 impedance settings could be tested in a period of one second. Once the "best" impedance setting is found, it is used until the next search is triggered.

In the discussion up to this point, it has been presumed that the channel is static and not changing. If the channel is fading, the techniques described herein will still work. If the channel is fading, the rate of change of the impedance setting for the IMC 106 should preferably be faster than the variations in the channel. The mobile terminal 100 may include detection circuits to detect fading and to perform antenna tuning only when the fading rate is below a predetermined threshold. Alternatively, the mobile terminal 100 may detect the mobility rate of the mobile terminal 100 and perform antenna tuning only when the fading rate is below a predetermined threshold. Mobility rate may be detected, for example, based on Doppler spread.

Also, various signal processing techniques can be used to separate the modulation of the power control feedback due to changes in the impedance settings from modulation of the power control feedback due to the fading channel. For example, assuming that the rate of fading is much lower than the rate of change in the impedance setting, a digital integrate and dump filter (IDF) may be used to detect modulations of the power control commands due to changes in the impedance setting. In this case, the IDF functions as a low-pass filter to filter out variations due to a slow fading channel. Alternatively, changes in the impedance setting may be made according to a predetermined code, such as a Barker code. Detection of the modulation of the power control commands due to changes in impedance settings can be made by correlating the power control command stream with the predetermined code.

While it is preferred to make changes to the impedance settings of the IMC 106 at a rate faster than the variations in the channel, such is not a necessary condition. If the changes to the impedance settings are slower than the changes in the channel, there are two possibilities. First, the tuning circuit 134 could make a single step change in the impedance setting of the IMC 106. If the effect of that step change is large enough (i.e., its size relative to the fading), the tuning circuit 134 could still make reasonable inferences about the impedance setting, Second, if the effect of the single step is ambiguous because it is not large enough, the tuning circuit 134 could take multiple steps up and down, and use coherent detection methods to detect the effect.

It should be appreciated that these more advanced methods of detecting the polarity and value of the improvement in power transfer between the transmitter 110 and antenna 102 permit the IMC 106 to be adjusted under any condition of channel fading. The consequence is that for more rapid and varied channel fading conditions, the time required to extract the information related to the impedance variation out of either the TPC data or transmitter power output data will be longer.

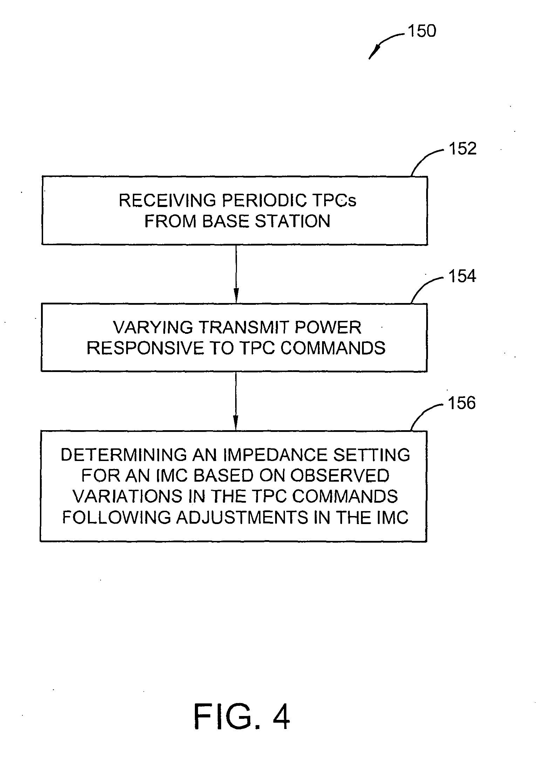

Fig. 4 illustrates an exemplary method 150 performed by the mobile terminal 100 for adjusting an IMC 106 coupling a transmitter 110 to a transmit antenna 102. The mobile terminal 100 receives periodic TPC commands from a base station 200 (block 152) and varies a transmit power of the transmit signal responsive to the power control commands (block 154). At some predetermined interval, or responsive to a predetermined condition, the mobile terminal 100 determines an impedance setting for the IMC 106 based on the power control commands following adjustment of the impedance matching circuit (block 156). Equivalently, the mobile terminal 100 may observe the changes in the transmitter output power (e.g. output of the transmitter 110 or power amplifier (not shown)) which track the TPC commands. Whereas the TPC commands are simple in nature, merely commanding the transmitter 110 to increase or decrease its output power by a known amount, the transmitter 110 will have information therein that, on either a relative basis or absolute basis, knows the transmitter output power level (as is shown in the lowest lines of Figs. 3A and 3B). For example, based on knowledge of the step size (typically 1 dB), the mobile terminal 100 is able to determine whether the change in impedance settings results in a relative increase or decrease in the power transfer to antenna 102. In the examples shown in Figs. 3A and 3B, there is an approximate 2 dB decrease in power transfer going from Setting 1 to Setting 2 and an approximate 3 dB increase in power transfer going from Setting 2 to Setting 3. It may be noted that while the antenna 102 is being tuned using the uplink path, often the same antenna 102 is used for the downlink and its performance in the downlink is also improved even though the frequencies for each uplink and downlink are slightly different.

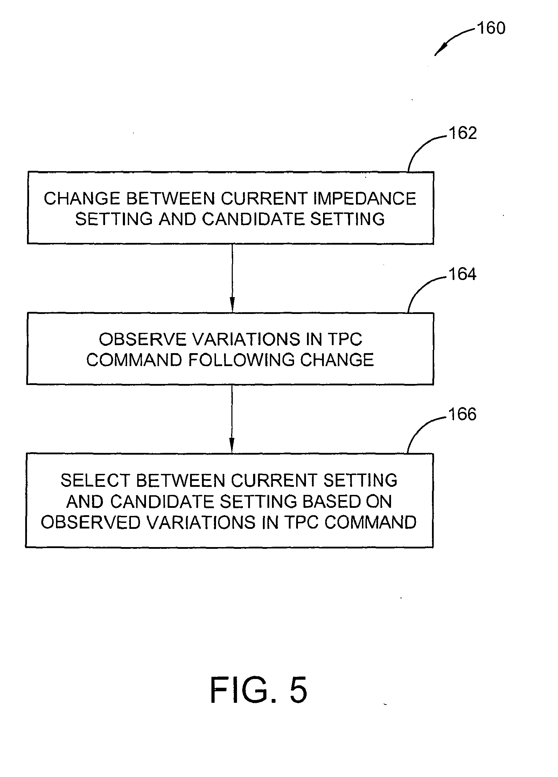

Fig. 5 illustrates one exemplary method 160 for determining the impedance setting in block 116. The method 160 directly compares two different impedance settings and selects between the two. More particularly, the antenna tuning circuit 134 changes between a current impedance setting for the IMC 106 and a candidate setting (block 162) and monitors the TPC commands following the changes (block 164). Depending on the TPC commands following the adjustment, the antenna tuning circuit 134 selects between the current setting and the candidate setting (block 166). As previously described, if one setting is demonstrably better than the other, switching between the two settings should result in a change in the ratio of up and down commands. The antenna tuning circuit 134 may compute a statistic of the TPC commands for each setting. The statistic may comprise a sum of the up and down commands, the ratio of up and down commands, or the average of the up and down commands.

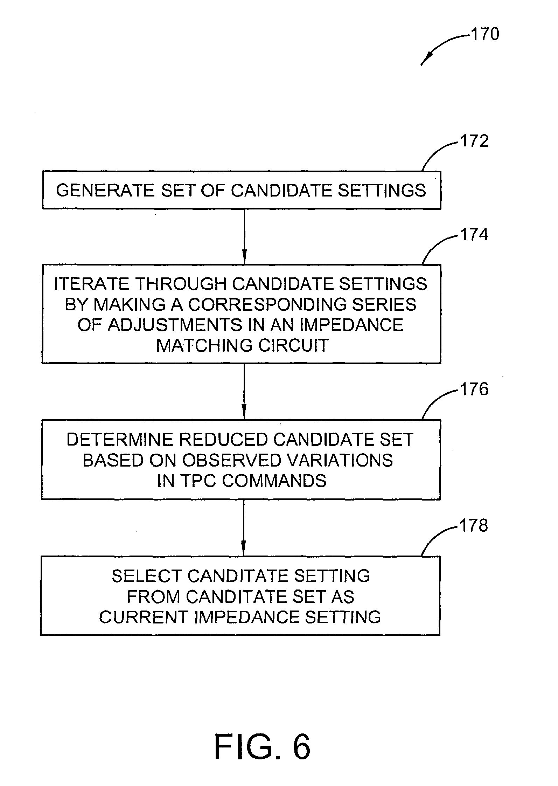

Fig. 6 illustrates an alternate method 170 for determining the impedance setting for the IMC 106. In this method, the antenna tuning circuit 134 generates a set of candidate settings (block 172). The candidate set may include the current setting. The antenna tuning circuit 134 then iterates through the candidate settings by making a corresponding series of adjustments in an impedance matching circuit 106 (block 174). The tuning circuit 134 then determines a reduced candidate set based on the TPC commands from the base station following the adjustment (block 176). For example, the turning circuit 134 may compute a statistic for each candidate setting based on the TPC commands observed in the observation interval following each change. The reduced candidate set may be determined based on the computed statistic. For example, if the computed statistic is the sum or average of the up and down commands, the tuning circuit 134 can select the candidate settings that correspond to local minima in the statistic. The reduction process (blocks 174 and 176) may be repeated to reduce the candidate set further. When the reduction of the candidate set is finished, the tuning circuit 134 selects a candidate setting from the candidate set as the current impedance setting (block 178). In some embodiments, the reduction process may be repeated until the candidate set is reduced to a single candidate. In this case, the final surviving candidate is selected as the current impedance setting. In other embodiments, the initial candidate set may be reduced to a small number. The procedure shown in Fig. 5 may then be used to select between the few surviving candidate settings.

In some embodiments of the invention, the tuning circuit 134 may receive input from a sensor 136 indicating the position of the user's hand or head relative to the mobile terminal 100, or other environmental factors affecting the load. When the tuning circuit 134 determines an impedance setting for the mobile terminal 100, the tuning circuit 134 may also store the current operating conditions at the time the impedance setting is determined. Thus, the mobile terminal 100 can store different impeding settings for different operating conditions in a look-up table (LUT) in memory. The mobile terminal 100 may use the stored settings to make coarse adjustments in the IMC 106 when the mobile terminal 100 detects changes in environmental conditions. The mobile terminal 100 may then use the methods described herein to fine tune the IMC 106.

The present invention may, of course, be carried out in other specific ways than those herein set forth without departing from the scope and essential characteristics of the invention. The present embodiments are, therefore, to be considered in all respects as illustrative and not restrictive, and all changes coming within the meaning and equivalency range of the appended claims are intended to be embraced therein.

## Claims

1. A method of adjusting an impedance matching circuit in a mobile terminal coupling a transmitter generating a transmit signal to a transmit antenna, said method comprising:
receiving periodic power control commands from a base station;
varying a transmit power of the transmit signal responsive to said power control
commands; and
determining an impedance setting for said impedance matching circuit based on
said power control commands following adjustment of said impedance matching circuit.

2. The method of claim 1 wherein determining an impedance setting for said impedance matching circuit comprises:
changing an impedance setting for the impedance matching circuit between a
current impedance setting and a candidate setting;
monitoring said power control commands following the change in the impedance
setting; and
selecting between the current impedance setting and the candidate setting based
on said power control commands.

3. The method of claim 1 wherein determining an impedance setting for said impedance matching circuit based on said power control commands comprises:
generating a set of candidate settings for the impedance matching circuit;
iterating through the candidate settings by making a series of adjustments in the
impedance setting for the impedance matching circuit;
determining a reduced set of candidate settings corresponding based on the
power control commands following said adjustments; and
selecting one of said candidate settings in said reduced candidate set as a
current impedance setting.

4. The method of claim 3 wherein determining a reduced set of candidate settings comprises:
computing a statistic of the power control commands following adjustments to
said impedance settings; and
finding the candidate settings that correspond to local minima in the statistic.

5. The method of claim 4 wherein computing a statistic of the power control commands following adjustments to said impedance settings comprises integrating the power control commands over a predetermined time period.

6. The method of claim 3 wherein determining a reduced set of candidate settings comprises recursively reducing the candidate set until the reduced candidate set contains a single candidate setting remains.

7. The method of claim 1 wherein determining an impedance setting for said impedance matching circuit based on said power control commands comprises:
determining two or more impedance settings for different operating conditions;
detecting a current operating condition of said mobile communication device; and
selecting an impedance setting determined based on the current operating
condition.

8. The method of claim 1 determining an impedance setting for said impedance matching circuit based on said power control commands comprises:
determining at least one of a mobility rate of the mobile terminal and a fading rate
of a channel between the mobile terminal and a serving base station; and determining the impedance matching circuit when one or both of the mobility rate
and the fading rate are below a corresponding threshold.

9. The method of claim 1 further comprising:
detecting a change in a proximate environment of the mobile communication
device; and
determining an impedance setting for said impedance matching circuit
responsive to the detected change in the proximate environment.

10. A mobile terminal comprising:
a transmitter for transmitting signal to a base station on an uplink channel;
a receiver to receive transmit power control commands from said base station on
a downlink control channel;
an impedance matching circuit coupled between the transmitter and a transmit
antenna; and
an antenna tuning circuit to determine an impedance setting for said impedance
matching circuit based on said power control commands following adjustment of said impedance matching circuit.

11. The mobile terminal of claim 10 wherein the antenna tuning circuit determines an impedance setting for said impedance matching circuit by:
changing an impedance setting for the impedance matching circuit between a
current impedance setting and a candidate setting;
monitoring said power control commands following the change in the impedance
setting; and
selecting between the current impedance setting and the candidate setting based
on said power control commands.

12. The mobile terminal of claim 10 wherein the antenna tuning circuit determines an impedance setting for said impedance matching circuit by:
generating a set of candidate settings for the impedance matching circuit;
iterating through the candidate settings by making a series of adjustments in the
impedance setting for the impedance matching circuit;
determining a reduced set of candidate settings based on the power control
commands following said adjustments; and
selecting one of said candidate settings in said reduced candidate set as a
current impedance setting.

13. The mobile terminal of claim 12 wherein the antenna tuning circuit determines a reduced set of candidate settings by:
computing a statistic of the power control commands following adjustments to
said impedance settings; and
finding the candidate settings that correspond to local minima in the statistic.

14. The mobile terminal of claim 10 wherein the antenna tuning circuit determines two or more impedance settings for different operating conditions and wherein the antenna tuning circuit is further configured to:
detect a current operating condition of said mobile communication device: and
select an impedance setting determined based on the current operating
condition.

15. The mobile terminal of claim 10 wherein the antenna tuning circuit is further configured to:
determine at least one of a mobility rate of the mobile terminal and a fading rate
of a channel between the mobile terminal and a serving base station; and
determine the impedance matching circuit when one or both of the mobility rate
and the fading rate are below a corresponding threshold.
